# EUROPEAN PATENT APPLICATION

(11) **EP 4 398 599 A1**
(43) Date of publication of application: **10.07.2024**
(21) Application number: 23150434.1
(22) Date of filing: 05.01.2023
(51) Int. Cl.: H04R 1/10, G06F 3/044, H03K 17/96

(54) **SIGNAL PROCESSING METHOD, HEARING DEVICE AND COMPUTER PROGRAM FOR DETERMINING A TAP ON THE HOUSING OF A HEARING DEVICE**

(71) Applicant: Oticon A/S, 2765 Smørum (DK)
(72) Inventor: EKSTRAND, Amalie Sofie, 2200 Copenhagen N (DK); THORIN, Jana, DK-2765 Smørum (DK); WESTERGAARD, Morten, DK-2765 Smørum (DK); BHUIYAN, Tanveer, DK-2765 Smørum (DK); WESTERGREN, Nicolai, DK-2765 Smørum (DK); LÕCSEI, Gusztáv, DK-2765 Smørum (DK); PEDERSEN, Michael Syskind, DK-2765 Smørum (DK)
(74) Representative: Demant

(57) **Abstract**

The invention relates to a signal processing method performed by a hearing device, for determining a tap on the housing of a hearing device, comprising: (a) obtaining at least one detected signal from at least one detector of the hearing device, wherein the at least one detector includes at least one microphone;(b) pre-processing at least one of the at least one detected signal for obtaining at least one pre-processed signal; (c) applying a band pass filter with a predetermined threshold for a maximum signal amplitude and with a predetermined duration to the at least one pre-processed signal; (d) counting how many times the at least one pre-processed signal exceeds and / or falls below the threshold for a maximum signal amplitude within the predetermined duration; and (e) determining if the at least one of the at least one detected signal corresponds to a true tap on the housing of the hearing device on the basis of the result of the counting. A correspondingly formed hearing device is also described.

## Description

### FIELD

The present invention relates to a signal processing method performed by a hearing device, for determining a tap on the housing of a hearing device, to a hearing device comprising a housing, at least one detector, at least one processor and at least one memory, and to a corresponding computer program.

### BACKGROUND

Hearing device, specifically hearing aids, are subject to particularly high requirements, especially in terms of comfort, appearance, size, robustness, etc. In general, it is desired that such devices can be worn on a daily basis and are practically invisible or at least can be hidden behind or in the earlobe. It is known to provide hearing aids with a relatively small housing and correspondingly small buttons for controlling diverse functions of the hearing aid. However, a fair portion of persons equipped with hearing aids are elderly or physically disabled, and with age and/ or disablement, the dexterity is deteriorated, making it hard to interact with the hearing aid using the small buttons. One way to alleviate this challenge is by allowing the user to interact with the hearing aid by tapping the instrument.

However, the manner a user performs a tap can vary greatly, especially in terms of force, making it difficult to detect a tap that should be considered as such, e.g., for a predetermined command, while sorting out detected other activities and/or sounds.

Against this background, it is an object of the present invention to provide a signal treatment method, a hearing device and a computer program for improving the user experience, in particular for allowing reliable recognition of a tap on the housing of the hearing device for a correct command of at least on functionality of the hearing device.

In particular, the present disclosure provides at least an alternative to the prior art.

### SUMMARY

The object named above is solved in accordance with the present invention by a signal processing method performed by a hearing device, for determining a tap on the housing of a hearing device, comprising: (a) obtaining at least one detected signal from at least one detector of the hearing device, wherein the at least one detector includes at least one microphone; (b) pre-processing at least one of the at least one detected signal for obtaining at least one pre-processed signal; (c) applying a band pass filter with a predetermined threshold for a maximum signal amplitude and with a predetermined duration to the at least one pre-processed signal; (d) counting how many times the at least one pre-processed signal exceeds and / or falls below the threshold for a maximum signal amplitude within the predetermined duration; and (e) determining if the at least one of the at least one detected signal corresponds to a true tap on the housing of the hearing device on the basis of the result of the counting.

The object named above is further solved in accordance with the present invention by a hearing device comprising a housing, at least one detector, at least one processor and at least one memory, characterized in that the memory stores instructions that, when executed by the at least one processor, causes the hearing device to at least perform: (a) obtaining at least one detected signal from at least one detector of the hearing device; (b) pre-processing at least one of the at least one detected signal for obtaining at least one pre-processed signal; (c) applying a band pass filter with a predetermined threshold for a maximum signal amplitude and with a predetermined duration to the at least one pre-processed signal; (d) counting how many times the at least one pre-processed signal exceeds and / or falls below the threshold for a maximum signal amplitude within the predetermined duration; and (e) determining if the at least one of the at least one detected signal corresponds to a true tap on the housing of the hearing device on the basis of the result of the counting.

The object named above is further solved in accordance with the present invention by a computer program comprising instructions which, when executed by a device, preferably a hearing device according to the invention, cause the device to perform the signal processing method according to the invention.

Applying a band-pass filter on the detected signal allows for a robust recognition of a tap, in particular when the threshold defining the top of the bad-pass filter is chosen in accordance with a signal amplitude that is regularly exceeded when a true tap occurs. In general, a recognition based on an analysis of a detected signal according to the invention allows, in particular for small custom designs of hearing aids, increasing the possibilities for commanding functions of the hearing aid. Also with the invention, a hearing aid can be provided without any buttons, while having improved user interface effect by means of a robust tap detection. Overall, the tap detection disclosed herein permits increasing the number of user interface handles.

Variations of the signal processing method, the haring device and the computer program are described in the following. The individual features are in each case individually applicable to the signal processing method, the haring device and the computer program. The individual features may furthermore be combined with each other.

According to an aspect of the signal processing method, at least one of the at least one detected signal is an audio signal, and wherein pre-processing in step (b) comprises: applying a first band pass filter for selecting low frequencies, a dead band filter and a smoothing filter to the audio signal for obtaining a first pre-processed audio signal; and applying a second band pass filter for selecting high frequencies, a dead band filter and a smoothing filter to the audio signal for obtaining a second pre-processed audio signal; wherein steps (c) and (d) are performed for both the first pre-processed audio signal and the second pre-processed audio signal; and wherein the determining of a true tap in step (e) is performed by taking into account the result of the counting for the first pre-processed audio signal and the result of the counting for the second pre-processed audio signal.

According to a corresponding aspect of the hearing device, at least one of the at least one detector is a microphone, and the instruction stored by the memory, when executed by the at least one processor, causes the hearing device to at least perform: (a) obtaining at least one detected audio signal from the at least one microphone; (b) pre-processing the at least one detected audio signal for obtaining at least one pre-processed audio signal, the pre-processing comprising: applying a first band pass filter for selecting low frequencies, a dead band filter and a smoothing filter to the audio signal for obtaining first pre-processed audio signal; and applying a second band pass filter for selecting high frequencies, a dead band filter and a smoothing filter to the audio signal for obtaining second pre-processed audio signal; (c) applying a band pass filter with a predetermined threshold for a maximum signal amplitude and with a predetermined duration to each of the first pre-processed audio signal and the second pre-processed audio signal; (d) counting how many times each of the of the first pre-processed audio signal and the second pre-processed audio signal exceeds and / or falls below the threshold for a maximum signal amplitude within the predetermined duration; and (e) determining if the at least one detected audio signal corresponds to a true tap on the housing of the hearing device by taking into account the result of the counting for the first pre-processed audio signal and the result of the counting for the second pre-processed audio signal....

By means of two band pass filters filtering at high and at low frequency ranges, the robustness of the tap detection can be improved.

Specifically, if in step (e) a tap is detected in the first band, but not in second band, a true tap is detected, and an action is carried out. If a tap is detected in the second band, no matter whether a tap is also detected in the first band, nothing will occur. This means that the second band acts as a control band to filter out false positives. According to an aspect of the signal processing method, in step (a), at least two detected signals comprising a first detected signal and a second detected signal are obtained from at least two detectors of the hearing device for the same detection time window, wherein the step (b) is performed for each of the first detected signal and the second detected signal for obtaining a first pre-processed signal and a second pre-processed signal; wherein the steps (c) and (d) are performed for each of the first pre-processed signal and the second pre-processed signal; and wherein the determining of a true tap in step (e) is performed by taking into account the result of the counting for the first pre-processed signal and the result of the counting for the second pre-processed signal.

According to a corresponding aspect of the hearing device, a first detector of the at least one detector is a microphone, a second detector of the at least one detector is an accelerometer, and the instruction stored by the memory, when executed by the at least one processor, causes the hearing device to at least perform: (a) obtaining a first signal detected by the first detector and a second signal detected by the second detector for the same detection time window; (b) pre-processing the first signal and the second signal for obtaining a first pre-processed signal and a second pre-processed signal; (c) applying a band pass filter with a predetermined threshold for a maximum signal amplitude and with a predetermined duration to each of the first pre-processed signal and the second pre-processed signal; (d) counting how many times each of the first pre-processed signal and the second pre-processed signal exceeds and / or falls below the threshold for a maximum signal amplitude within the predetermined duration; and (e) determining if the at least two detected signals correspond to a true tap on the housing of the hearing device by taking into account the result of the counting for the first pre-processed signal and the result of the counting for the second pre-processed signal....

Also taking two detected signals into account improves the robustness of the recognition and the probability of sorting out false taps. In particular, the two-band processing allows for increased reliability by applying a logic in the tap algorithm. The logic states that if a tap is detected in the first band, but not in second band, a true tap is detected, and an action is carried out. If a tap is detected in the second band, no matter whether a tap is also detected in the first band, nothing will occur. This means that the second band acts as a control band to filter out false positives.

According to an aspect of the signal processing method, the first detected signal and the second detected signal are audio signals.

According to a corresponding aspect of the hearing device, a first detector of the at least one detector is a first microphone and a second detector of the at least one detector is a second microphone, and the instruction stored by the memory, when executed by the at least one processor, causes the hearing device to at least perform: (a) obtaining a first signal detected by the first detector and a second signal detected by the second detector for the same detection time window; (b) pre-processing the first signal and the second signal for obtaining a first pre-processed signal and a second pre-processed signal; (c) applying a band pass filter with a predetermined threshold for a maximum signal amplitude and with a predetermined duration to each of the first pre-processed signal and the second pre-processed signal; (d) counting how many times each of the first pre-processed signal and the second pre-processed signal exceeds and / or falls below the threshold for a maximum signal amplitude within the predetermined duration; and (e) determining if the first signal and the second signal correspond to a true tap on the housing of the hearing device by taking into account the result of the counting for the first pre-processed signal and the result of the counting for the second pre-processed signal....

The two signals may be detected by two microphones, e.g. from two hearing aids that are arranged each at one ear of the equipped person, or by two microphones arranged at a same ear. With this, the logic described above can be implemented in hearing existing hearing aids, since a fair amount of existing design already have two microphones.

Accordingly, an additional layer of logic can be applied if the user is wearing two hearing aids, it is not a requirement, but adds further reliability. The same processing is applied in both hearing aids, but if a tap is detected on both sides, only in the first band, simultaneously, nothing will occur. Since the user should only be tapping on one instrument at a time. If a tap is detected binaurally, it is known to be a false positive. An example, where the binaural processing would be beneficial, would be in the case of a low frequency sound, with a sharp onset, being detected binaurally in the first band as a tap. This would be prevented by binaural processing.

According to an aspect of the signal processing method, the first detected signal is a signal outputted by an accelerometer, and wherein the second detected signal is an audio signal....

The acceleration due to a tap is affected by the force (and acceleration) at which the user is tapping, but the microphone signal is less affected by the force. For the microphone signal, the style of tapping, e.g., tapping with a single finger vs whole hand, tapping on the instrument vs tapping on, e.g., the pinna, may be a source of variation in the tap signal. However, for both the accelerometer signal and the microphone signal a tap will be reflected as a peak. A signal that resembles a tap both in terms of audio and acceleration is highly unlikely. For a true tap, the two signals are complementary and give rise to a robust tap detection algorithm. From user studies, it is known that, if taps where available for volume control, the volume control was used significantly more by the user, showing that a robust tap functionality increases the user friendliness.

According to an aspect of the signal processing method, in step (a), at least three detected signals comprising a first detected signal, a second detected signal and a third detected signal are obtained from at least three detectors of the hearing device for the same detection time window, wherein the step (b) is performed for each of the first detected signal, the second detected signal and the third detected signal for obtaining a first pre-processed signal, a second pre-processed signal and a third pre-processed signal; wherein the steps (c) and (d) are performed for each of the first pre-processed signal, the second pre-processed signal and the third pre-processed signal; and wherein the determining of a true tap in step (e) is performed by taking into account the result of the counting for the first pre-processed signal, the result of the counting for the second pre-processed signal and the result of the third pre-processed signal.

According to a corresponding aspect of the hearing device, a first detector of the at least one detector is a first microphone, a second detector of the at least one detector is a second microphone and a third detector of the at least one detector is a proximity sensor, and the memory stores instructions that, when executed by the at least one processor, causes the hearing device to at least to perform: (a) obtaining a first signal detected by the first detector, a second signal detected by the second detector and a third signal detected by the third detector for the same detection time window; (b) pre-processing the first signal, the second signal and the third signal for obtaining a first pre-processed signal, a second pre-processed signal and a third pre-processed signal; (c) applying a band pass filter with a predetermined threshold for a maximum signal amplitude and with a predetermined duration to each of the first pre-processed signal, the second pre-processed signal and the third pre-processed signal; (d) counting how many times each of the first pre-processed signal, the second pre-processed signal and the third pre-processed signal exceeds and / or falls below the threshold for a maximum signal amplitude within the predetermined duration; and (e) determining if the first signals, the second signal and the third signal correspond to a true tap on the housing of the hearing device by taking into account the result of the counting for the first pre-processed signal, the result of the counting for the second pre-processed signal and the result of the counting for the third pre-processed signal.

Here, both the advantages of a binaural detection with two microphone signals and of sorting out false detection by combining audio signals with other kinds of detected signals can be combined. In particular, several constellations of signals can be envisaged, e.g. three audio signals, two audio signals and an accelerator signal, two accelerator signals and one audio signal, or three accelerator signals.

According to an aspect of the signal processing method, the first detected signal is an audio signal, wherein the second detected signal is a signal outputted by an accelerometer, and wherein the third detected signal is a signal outputted by a proximity sensor.

By taking different kinds of detected signals into account, the recognition of a true tap can be based on a greater variety of criteria of parameter characterizing a true tap. With this, the probability of recognition of an actual true tap is improved accordingly.

According to an aspect of the signal processing method, in step (e), a true single tap is positively determined if each of the at least one pre-processed signals first exceeds and then falls below the threshold for a maximum signal amplitude within the predetermined duration, and wherein, in step (e), a true double tap is positively determined if each of the at least one pre-processed signals first exceeds and then falls below the threshold for a maximum signal amplitude for a first time and exceeds and then falls below the threshold for a maximum signal amplitude for a second time within the predetermined duration.

Accordingly, a true tap and a double tap can both be recognized, and also be differentiated, so that the number of user handle and variation possibilities for entering a command into the hearing device is enhanced.

According to an aspect of the hearing device, the hearing device is or comprises a hearing aid.

According to an aspect of the hearing device, the processor is adapted for controlling at least one function of the hearing device in dependence of the result of determining of a true tap on the housing of the hearing aid.

The electronic hardware may include micro-electronic-mechanical systems (MEMS), integrated circuits (e.g. application specific), microprocessors, microcontrollers, digital signal processors (DSPs), field programmable gate arrays (FPGAs), programmable logic devices (PLDs), gated logic, discrete hardware circuits, printed circuit boards (PCB) (e.g. flexible PCBs), and other suitable hardware configured to perform the various functionality described throughout this disclosure, e.g. sensors, e.g. for sensing and/or registering physical properties of the environment, the device, the user, etc. Computer program shall be construed broadly to mean instructions, instruction sets, code, code segments, program code, programs, subprograms, software modules, applications, software applications, software packages, routines, subroutines, objects, executables, threads of execution, procedures, functions, etc., whether referred to as software, firmware, middleware, microcode, hardware description language, or otherwise.

A hearing device (or hearing instrument, hearing assistance device) may be or include a hearing aid that is adapted to improve or augment the hearing capability of a user by receiving an acoustic signal from a user's surroundings, generating a corresponding audio signal, possibly modifying the audio signal and providing the possibly modified audio signal as an audible signal to at least one of the user's ears. 'Improving or augmenting the hearing capability of a user' may include compensating for an individual user's specific hearing loss. The "hearing device" may further refer to a device such as a hearable, an earphone or a headset adapted to receive an audio signal electronically, possibly modifying the audio signal and providing the possibly modified audio signals as an audible signal to at least one of the user's ears. Such audible signals may be provided in the form of an acoustic signal radiated into the user's outer ear, or an acoustic signal transferred as mechanical vibrations to the user's inner ears through bone structure of the user's head and/or through parts of the middle ear of the user or electric signals transferred directly or indirectly to the cochlear nerve and/or to the auditory cortex of the user.

The hearing device is adapted to be worn in any known way. This may include i) arranging a unit of the hearing device behind the ear with a tube leading air-borne acoustic signals into the ear canal or with a receiver/ loudspeaker arranged close to or in the ear canal and connected by conductive wires (or wirelessly) to the unit behind the ear, such as in a Behind-the-Ear type hearing aid, and/ or ii) arranging the hearing device entirely or partly in the pinna and/ or in the ear canal of the user such as in an In-the-Ear type hearing aid or In-the-Canal/ Completely-in-Canal type hearing aid, or iii) arranging a unit of the hearing device attached to a fixture implanted into the skull bone such as in a Bone Anchored Hearing Aid or a Cochlear Implant, or iv) arranging a unit of the hearing device as an entirely or partly implanted unit such as in a Bone Anchored Hearing Aid or a Cochlear Implant. The hearing device may be implemented in one single unit (housing) or in a number of units individually connected to each other.

A "hearing system" refers to a system comprising one or two hearing devices, and a "binaural hearing system" refers to a system comprising two hearing devices where the devices are adapted to cooperatively provide audible signals to both of the user's ears. The hearing system or binaural hearing system may further include one or more auxiliary device(s) that communicates with at least one hearing device, the auxiliary device affecting the operation of the hearing devices and/or benefitting from the functioning of the hearing devices. A wired or wireless communication link between the at least one hearing device and the auxiliary device is established that allows for exchanging information (e.g. control and status signals, possibly audio signals) between the at least one hearing device and the auxiliary device. Such auxiliary devices may include at least one of a remote control, a remote microphone, an audio gateway device, a wireless communication device, e.g. a mobile phone (such as a smartphone) or a tablet or another device, e.g. comprising a graphical interface, a public-address system, a car audio system or a music player, or a combination thereof. The audio gateway may be adapted to receive a multitude of audio signals such as from an entertainment device like a TV or a music player, a telephone apparatus like a mobile telephone or a computer, e.g. a PC. The auxiliary device may further be adapted to (e.g. allow a user to) select and/or combine an appropriate one of the received audio signals (or combination of signals) for transmission to the at least one hearing device. The remote control is adapted to control functionality and/or operation of the at least one hearing device. The function of the remote control may be implemented in a smartphone or other (e.g. portable) electronic device, the smartphone / electronic device possibly running an application (APP) that controls functionality of the at least one hearing device.

In general, a hearing device includes i) an input unit such as a microphone for receiving an acoustic signal from a user's surroundings and providing a corresponding input audio signal, and/or ii) a receiving unit for electronically receiving an input audio signal. The hearing device further includes a signal processing unit for processing the input audio signal and an output unit for providing an audible signal to the user in dependence on the processed audio signal.

The input unit may include multiple input microphones, e.g. for providing direction-dependent audio signal processing. Such directional microphone system is adapted to (relatively) enhance a target acoustic source among a multitude of acoustic sources in the user's environment and/or to attenuate other sources (e.g. noise). In one aspect, the directional system is adapted to detect (such as adaptively detect) from which direction a particular part of the microphone signal originates. This may be achieved by using conventionally known methods. The signal processing unit may include an amplifier that is adapted to apply a frequency dependent gain to the input audio signal. The signal processing unit may further be adapted to provide other relevant functionality such as compression, noise reduction, etc. The output unit may include an output transducer such as a loudspeaker/ receiver for providing an air-borne acoustic signal trans cutaneously or percutaneously to the skull bone or a vibrator for providing a structure-borne or liquid-borne acoustic signal.

A computer program (product) comprising instructions which, when the program is executed by a computer, cause the computer to carry out (steps of) the method described above, in the 'detailed description of embodiments' and in the claims is furthermore provided by the present application.

In an aspect, the functions may be stored on or encoded as one or more instructions or code on a tangible computer-readable medium. The computer readable medium includes computer storage media adapted to store a computer program comprising program codes, which when run on a processing system causes the data processing system to perform at least some (such as a majority or all) of the steps of the method described above, in the and in the claims.

By way of example, and not limitation, such computer-readable media can comprise RAM, ROM, EEPROM, CD-ROM or other optical disk storage, magnetic disk storage or other magnetic storage devices, or any other medium that can be used to carry or store desired program code in the form of instructions or data structures and that can be accessed by a computer. Disk and disc, as used herein, includes compact disc (CD), laser disc, optical disc, digital versatile disc (DVD), floppy disk and Blu-ray disc where disks usually reproduce data magnetically, while discs reproduce data optically with lasers. Combinations of the above should also be included within the scope of computer-readable media. In addition to being stored on a tangible medium, the computer program can also be transmitted via a transmission medium such as a wired or wireless link or a network, e.g. the Internet, and loaded into a data processing system for being executed at a location different from that of the tangible medium.

In an aspect, a data processing system comprising a processor adapted to execute the computer program for causing the processor to perform at least some (such as a majority or all) of the steps of the method described above and in the claims.

It is intended that the structural features of the devices described above, either in the detailed description and/or in the claims, may be combined with steps of the method, when appropriately substituted by a corresponding process.

As used, the singular forms "a," "an," and "the" are intended to include the plural forms as well (i.e. to have the meaning "at least one"), unless expressly stated otherwise. It will be further understood that the terms "includes," "comprises," "including," and/or "comprising," when used in this specification, specify the presence of stated features, integers, steps, operations, elements, and/or components, but do not preclude the presence or addition of one or more other features, integers, steps, operations, elements, components, and/or groups thereof. It will also be understood that when an element is referred to as being "connected" or "coupled" to another element, it can be directly connected or coupled to the other element, but an intervening element may also be present, unless expressly stated otherwise.

Furthermore, "connected" or "coupled" as used herein may include wirelessly connected or coupled. As used herein, the term "and/or" includes any and all combinations of one or more of the associated listed items. The steps of any disclosed method are not limited to the exact order stated herein, unless expressly stated otherwise.

It should be appreciated that reference throughout this specification to "one embodiment" or "an embodiment" or "an aspect" or features included as "may" means that a particular feature, structure or characteristic described in connection with the embodiment is included in at least one embodiment of the disclosure. Furthermore, the particular features, structures or characteristics may be combined as suitable in one or more embodiments of the disclosure. The previous description is provided to enable any person skilled in the art to practice the various aspects described herein. Various modifications to these aspects will be readily apparent to those skilled in the art, and the generic principles defined herein may be applied to other aspects. Reference to an element in the singular is not intended to mean "one and only one" unless specifically so stated, but rather "one or more." Unless specifically stated otherwise, the term "some" refers to one or more.

Accordingly, the scope should be judged in terms of the claims that follow.

Further features and advantages of signal processing method, the hearing device and the computer program emerge from the following description where reference is made to the attached drawing.

### BRIEF DESCRIPTION OF THE DRAWINGS

The aspects of the disclosure may be best understood from the following detailed description taken in conjunction with the accompanying figures. The figures are schematic and simplified for clarity, and they just show details to improve the understanding of the claims, while other details are left out. Throughout, the same reference numerals are used for identical or corresponding parts. The individual features of each aspect may each be combined with any or all features of the other aspects. These and other aspects, features and/or technical effect will be apparent from and elucidated with reference to the illustrations described hereinafter in which:
- Fig. 1: shows a flow chart of an algorithm for accelerometer-based tap detection;
- Fig. 2: shows a flow chart of an algorithm for microphone-based tap detection;
- Fig. 3: shows an accelerator signal and a microphone signal recording a true tap;
- Fig. 4: shows a schematic of the representation of a false tap in the form of a double clap;
- Fig. 5: shows a microphone-based tap detection algorithm flow chart; and
- Fig. 6: shows frequency spectra for microphone detected double tap, double clap and double ballpen click.

### DETAILED DESCRIPTION OF THE DRAWINGS

The detailed description set forth below in connection with the appended drawings is intended as a description of various configurations. The detailed description includes specific details for the purpose of providing a thorough understanding of various concepts. However, it will be apparent to those skilled in the art that these concepts may be practiced without these specific details. Several aspects of the apparatus and methods are described by various blocks, functional units, modules, components, circuits, steps, processes, algorithms, etc. (collectively referred to as "elements"). Depending upon particular application, design constraints or other reasons, these elements may be implemented using electronic hardware, computer program, or any combination thereof.

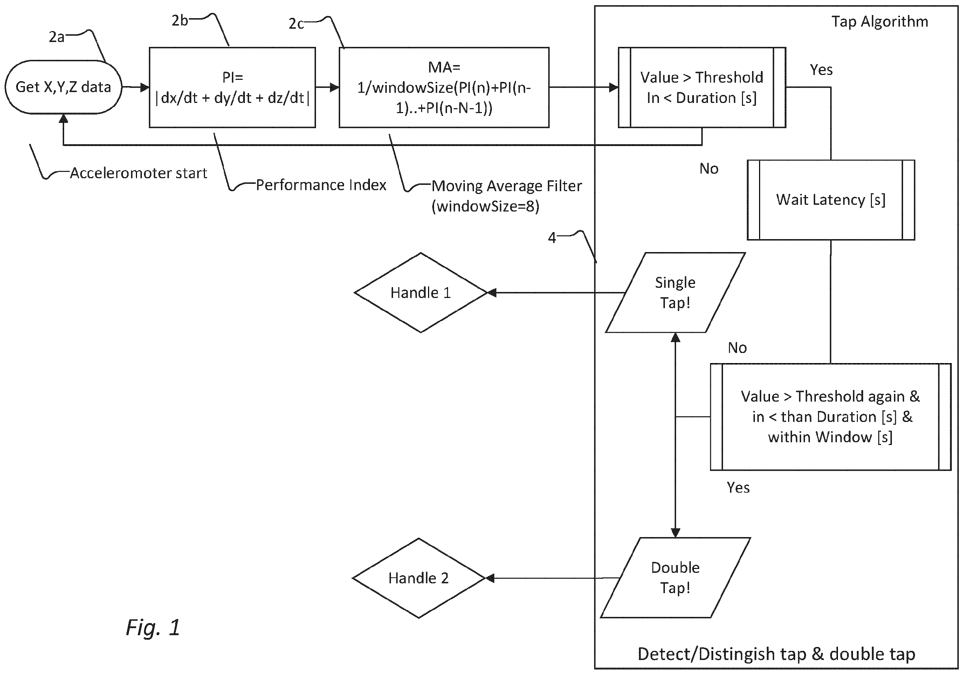

Fig. 1 shows a flow chart of an algorithm for accelerometer-based tap detection. The first three blocks 2a, 2b, 2c constitute the pre-processing (performance index and moving average/IIR filter parameterized by a time constant), whereas the right area 4 is the tap detection algorithm, which may be reused and adapted to the audio signal as well.

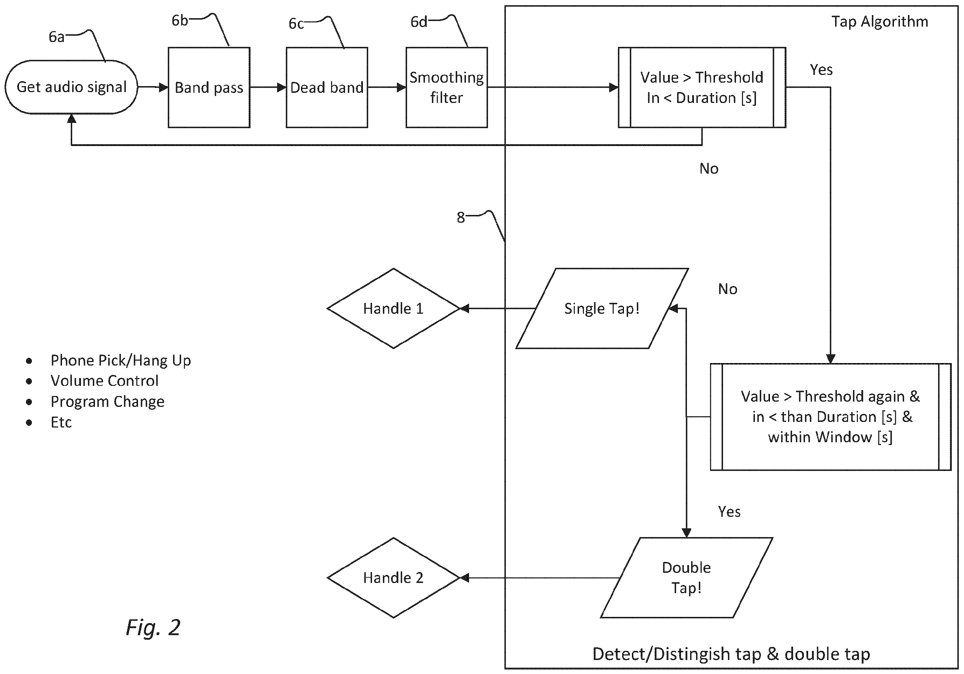

Fig. 2 shows a flow chart of an algorithm for microphone-based tap detection. The first four blocks 6a, 6b, 6c, 6d constitute the pre-processing (band pass filter, a dead band to remove irrelevant signals, a smoothing filter), whereas the right area 8 is the tap detection algorithm developed for the accelerometer-based tap detection but adapted and reused for the microphone-based solution.

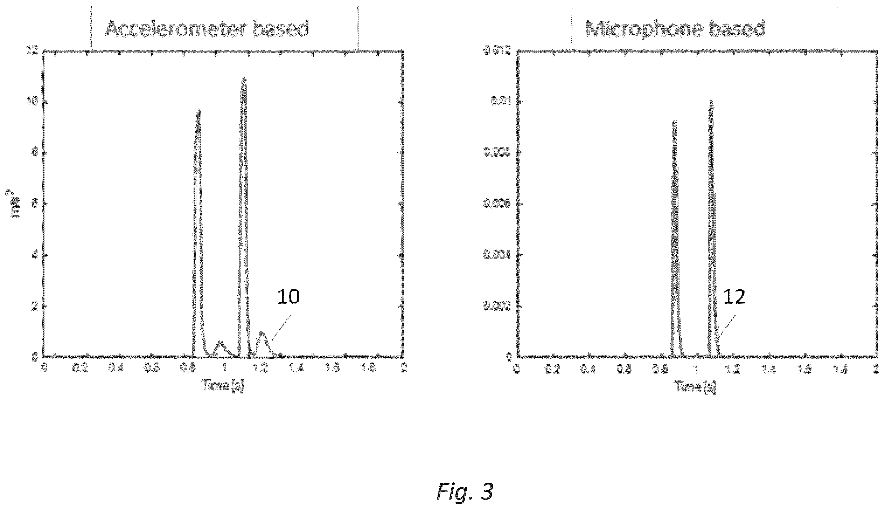

Fig. 3 shows an accelerator signal 10 and a microphone signal 12 recording a true tap. On the right-hand side, a tap as it is picked up in the processed microphone signal and on the left-hand side, a tap as it is picked up in the processed accelerometer signal. The two signals are comparable in terms of waveform, but not magnitude.

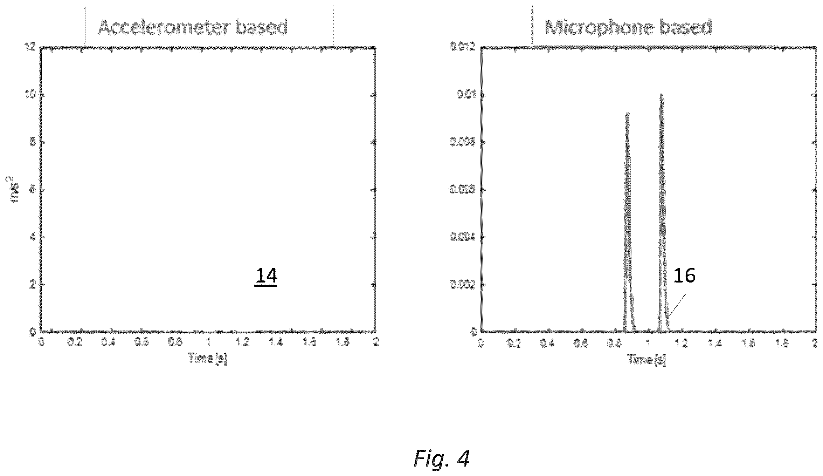

Fig. 4 shows a schematic of the representation of a false tap under the form of a double clap. On the right-hand side, a double clap as it is picked up in the processed microphone signal 16 and on the left-hand side, a double clap as it is picked up in the processed accelerometer signal 14. The claps are picked up by the microphone signal 16, but as the hearing aid is not touched, the accelerometer is not affected. Hence, only a "microphone-tap" is detected, whereby it is correctly defined as a false positive and no tap action is carried out.

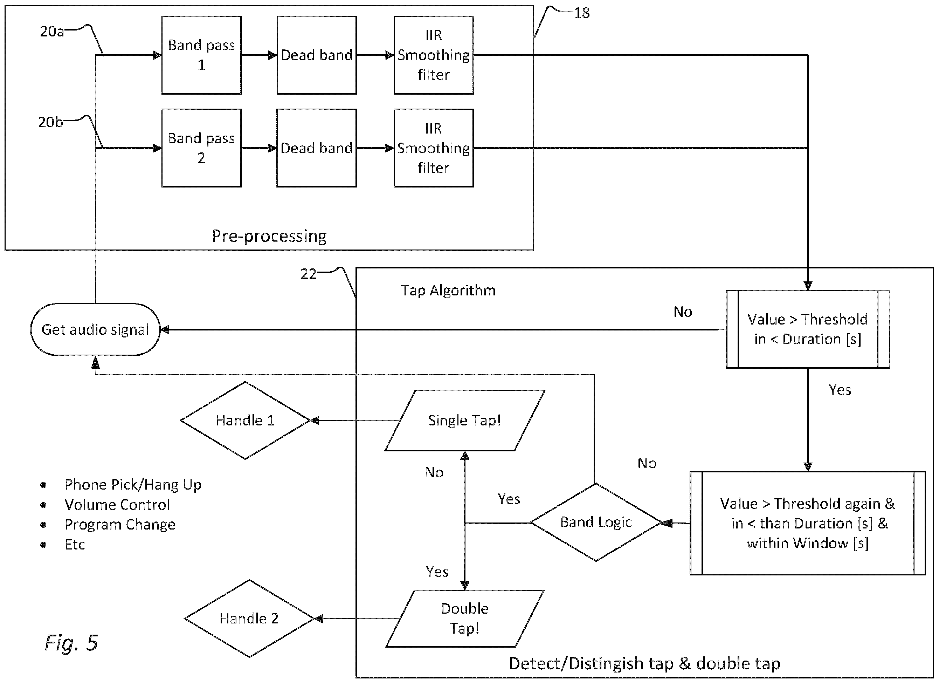

Fig. 5 shows a microphone-based tap detection algorithm flow chart. The pre-processing step 18 (shown at the top left hand side) is processing the audio signal in two bands 20a, 20b. The audio signal is divided into two bands using two bandpass filters with different cut off frequencies. The subsequent processing steps are identical for both of the bands. In that, the band pass filters are followed by a deadband and an IIR smoothing filter. The pre-processed signal from each band is then getting classified by the audio signal-adapted tap algorithm 22 (on the bottom right hand side), which determines whether a tap is detected or not.

The first band 20a is intended to catch true taps whereas, the second band 20b is designed to catch false positive prone activities such as clapping, which have a higher dominant frequency. The second band 20b thereby works as a control band. The band pass filters are followed by a deadband. The deadband sets all values below a certain threshold to zero, values above the given threshold are passed through without change. The last step of the pre-processing block is the IIR smoothing filter. The purpose of this block is, as the name states, to smoothen the signal in order to achieve a remove rapid fluctuations in the signal (added by the band pass filter). The morphology of the pre-processed audio signal output is very similar to the pre-processed accelerometer signal output, which makes it possible to re-use the original tap algorithm, with parameters tuned specifically for the audio signal and with an added logic gate.

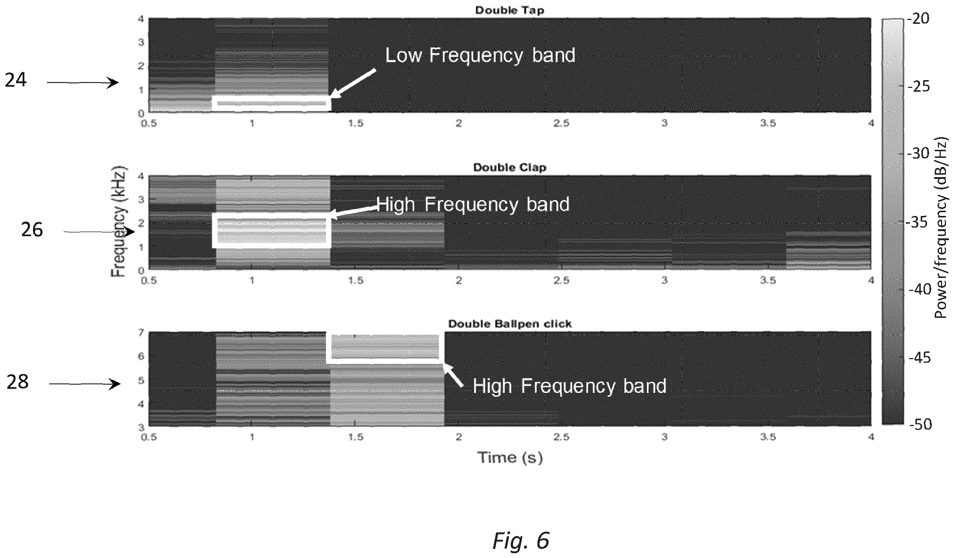

Fig. 6 shows frequency spectra for microphone detected double tap 24, double clap 26 and double ballpen click 28, clearly indicating that the dominating frequency of tap is at a lower frequency than clap and ballpen click. In the represented three cases, no action would be carried out, as these signals would be recognized as false taps.

## Claims

1. Signal processing method performed by a hearing device, for determining a tap on the housing of a hearing device, comprising: (a) obtaining at least one detected signal from at least one detector of the hearing device, wherein the at least one detector includes at least one microphone;
(b) pre-processing at least one of the at least one detected signal for obtaining at least one pre-processed signal;
(c) applying a band pass filter with a predetermined threshold for a maximum signal amplitude and with a predetermined duration to the at least one pre-processed signal;
(d) counting how many times the at least one pre-processed signal exceeds and / or falls below the threshold for a maximum signal amplitude within the predetermined duration; and
(e) determining if the at least one of the at least one detected signal corresponds to a true tap on the housing of the hearing device on the basis of the result of the counting.

2. Signal processing method according to claim 1 or 2, - wherein at least one of the at least one detected signal is an audio signal, and
- wherein pre-processing in step (b) comprises:
- applying a first band pass filter for selecting low frequencies, a dead band filter and a smoothing filter to the audio signal for obtaining a first pre-processed audio signal; and
- applying a second band pass filter for selecting high frequencies, a dead band filter and a smoothing filter to the audio signal for obtaining a second pre-processed audio signal;
- wherein steps (c) and (d) are performed for both the first pre-processed audio signal and the second pre-processed audio signal; and
- wherein the determining of a true tap in step (e) is performed by taking into account the result of the counting for the first pre-processed audio signal and the result of the counting for the second pre-processed audio signal.

3. Signal processing method according to any one of the claims 1 or 2, - wherein, in step (a), at least two detected signals comprising a first detected signal and a second detected signal are obtained from at least two detectors of the hearing device for the same detection time window,
- wherein the step (b) is performed for each of the first detected signal and the second detected signal for obtaining a first pre-processed signal and a second pre-processed signal;
- wherein the steps (c) and (d) are performed for each of the first pre-processed signal and the second pre-processed signal; and
- wherein the determining of a true tap in step (e) is performed by taking into account the result of the counting for the first pre-processed signal and the result of the counting for the second pre-processed signal.

4. Signal processing method according to claim 3,- wherein the first detected signal and the second detected signal are audio signals.

5. Signal processing method according to claim 3,- wherein the first detected signal is a signal outputted by an accelerometer, and
- wherein the second detected signal is an audio signal.

6. Signal processing method according to any one of claims 4 to 6,- wherein, in step (a), at least three detected signals comprising a first detected signal, a second detected signal and a third detected signal are obtained from at least three detectors of the hearing device for the same detection time window,
- wherein the step (b) is performed for each of the first detected signal, the second detected signal and the third detected signal for obtaining a first pre-processed signal, a second pre-processed signal and a third pre-processed signal;
- wherein the steps (c) and (d) are performed for each of the first pre-processed signal, the second pre-processed signal and the third pre-processed signal; and
- wherein the determining of a true tap in step (e) is performed by taking into account the result of the counting for the first pre-processed signal, the result of the counting for the second pre-processed signal and the result of the third pre-processed signal.

7. Signal processing method according to claim 6, - wherein the first detected signal is an audio signal,
- wherein the second detected signal is a signal outputted by an accelerometer, and
- wherein the third detected signal is a signal outputted by a proximity sensor.

8. Signal processing method according to any one of claims 1 to 7, - wherein, in step (e), a true single tap is positively determined if each of the at least one pre-processed signals first exceeds and then falls below the threshold for a maximum signal amplitude within the predetermined duration, and
- wherein, in step (e), a true double tap is positively determined if each of the at least one pre-processed signals first exceeds and then falls below the threshold for a maximum signal amplitude for a first time and exceeds and then falls below the threshold for a maximum signal amplitude for a second time within the predetermined duration.

9. Hearing device comprising-a housing,
- at least one detector,
- at least one processor and
- at least one memory,
**characterized in that**
- the memory stores instructions that, when executed by the at least one processor, causes the hearing device to at least perform:
(a) obtaining at least one detected signal from at least one detector of the hearing device;
(b) pre-processing at least one of the at least one detected signal for obtaining at least one pre-processed signal;
(c) applying a band pass filter with a predetermined threshold for a maximum signal amplitude and with a predetermined duration to the at least one pre-processed signal;
(d) counting how many times the at least one pre-processed signal exceeds and / or falls below the threshold for a maximum signal amplitude within the predetermined duration; and
(e) determining if the at least one of the at least one detected signal corresponds to a true tap on the housing of the hearing device on the basis of the result of the counting.

10. Hearing device according to claim 9,**characterized in that**
- at least one of the at least one detector is a microphone, and
- the instruction stored by the memory, when executed by the at least one processor, causes the hearing device to at least perform:
(a) obtaining at least one detected audio signal from the at least one microphone;
(b) pre-processing the at least one detected audio signal for obtaining at least one pre-processed audio signal, the pre-processing comprising:
- applying a first band pass filter for selecting low frequencies, a dead band filter and a smoothing filter to the audio signal for obtaining first pre-processed audio signal; and
- applying a second band pass filter for selecting high frequencies, a dead band filter and a smoothing filter to the audio signal for obtaining second pre-processed audio signal;
(c) applying a band pass filter with a predetermined threshold for a maximum signal amplitude and with a predetermined duration to each of the first pre-processed audio signal and the second pre-processed audio signal;
(d) counting how many times each of the of the first pre-processed audio signal and the second pre-processed audio signal exceeds and / or falls below the threshold for a maximum signal amplitude within the predetermined duration; and
(e) determining if the at least one detected audio signal corresponds to a true tap on the housing of the hearing device by taking into account the result of the counting for the first pre-processed audio signal and the result of the counting for the second pre-processed audio signal.

11. Hearing device according to claim 9 or 10,**characterized in that**
- a first detector of the at least one detector is a microphone,
- a second detector of the at least one detector is an accelerometer, and
- the instruction stored by the memory, when executed by the at least one processor, causes the hearing device to at least perform:
(a) obtaining a first signal detected by the first detector and a second signal detected by the second detector for the same detection time window;
(b) pre-processing the first signal and the second signal for obtaining a first pre-processed signal and a second pre-processed signal;
(c) applying a band pass filter with a predetermined threshold for a maximum signal amplitude and with a predetermined duration to each of the first pre-processed signal and the second pre-processed signal;
(d) counting how many times each of the first pre-processed signal and the second pre-processed signal exceeds and / or falls below the threshold for a maximum signal amplitude within the predetermined duration; and
(e) determining if the at least two detected signals correspond to a true tap on the housing of the hearing device by taking into account the result of the counting for the first pre-processed signal and the result of the counting for the second pre-processed signal.

12. Hearing device according to any one of claims 9 to 11,**characterized in that**
- a first detector of the at least one detector is a first microphone and a second detector of the at least one detector is a second microphone, and
- the instruction stored by the memory, when executed by the at least one processor, causes the hearing device to at least perform:
(a) obtaining a first signal detected by the first detector and a second signal detected by the second detector for the same detection time window;
(b) pre-processing the first signal and the second signal for obtaining a first pre-processed signal and a second pre-processed signal;
(c) applying a band pass filter with a predetermined threshold for a maximum signal amplitude and with a predetermined duration to each of the first pre-processed signal and the second pre-processed signal;
(d) counting how many times each of the first pre-processed signal and the second pre-processed signal exceeds and / or falls below the threshold for a maximum signal amplitude within the predetermined duration; and
(e) determining if the first signal and the second signal correspond to a true tap on the housing of the hearing device by taking into account the result of the counting for the first pre-processed signal and the result of the counting for the second pre-processed signal.

13. Hearing device according to any one of the claims 10 to 12,**characterized in that**
- a first detector of the at least one detector is a first microphone, a second detector of the at least one detector is a second microphone and a third detector of the at least one detector is a proximity sensor, and
- the memory stores instructions that, when executed by the at least one processor, causes the hearing device to at least to perform:
(a) obtaining a first signal detected by the first detector, a second signal detected by the second detector and a third signal detected by the third detector for the same detection time window;
(b) pre-processing the first signal, the second signal and the third signal for obtaining a first pre-processed signal, a second pre-processed signal and a third pre-processed signal;
(c) applying a band pass filter with a predetermined threshold for a maximum signal amplitude and with a predetermined duration to each of the first pre-processed signal, the second pre-processed signal and the third pre-processed signal;
(d) counting how many times each of the first pre-processed signal, the second pre-processed signal and the third pre-processed signal exceeds and / or falls below the threshold for a maximum signal amplitude within the predetermined duration; and
(e) determining if the first signals, the second signal and the third signal correspond to a true tap on the housing of the hearing device by taking into account the result of the counting for the first pre-processed signal, the result of the counting for the second pre-processed signal and the result of the counting for the third pre-processed signal.

14. Hearing device according to any one of the claims 9 to 13, wherein the hearing device is or comprises a hearing aid.

15. Hearing device according to any one of the claims 9 to 14, wherein the processor is adapted for controlling at least one function of the hearing device in dependence of the result of determining of a true tap on the housing of the hearing aid.

16. Computer program comprising instructions which, when executed by a device, preferably a hearing device according to any one of the claims 9 to 15, cause the device to perform the signal processing method according to any one of the claims 1 to 8.
